# EUROPEAN PATENT APPLICATION

(11) **EP 4 661 068 A1**
(43) Date of publication of application: **10.12.2025**
(21) Application number: 24180440.0
(22) Date of filing: 06.06.2024
(51) Int. Cl.: H01L 21/822, H01L 21/8238, H01L 27/06, H01L 27/092, H01L 29/06, H01L 29/423, H01L 29/66, H01L 29/775

(54) **SEMICONDUCTOR STRUCTURE AND A METHOD OF FABRICATING THEREOF**

(71) Applicant: Huawei Technologies Co., Ltd., Shenzhen, Guangdong 518129 (CN)
(72) Inventor: BHUWALKA, Krishna Kumar, 80992 Munich (DE)
(74) Representative: Körber, Martin Hans

(57) **Abstract**

A method comprises forming a first stack of nanosheet layers on a substrate, forming a second stack of nanosheet layers on the first stack of nanosheet layers, wherein the nanosheet layers of the first stack and the second stack each comprise alternating silicon layers and silicon-germanium layers, wherein the silicon layers of the first stack have a first thickness and the silicon layers of the second stack have a second thickness, wherein the first stack and the second stack are separated by a sacrificial layer having a thickness greater than a thickness of the silicon-germanium layers of the first stack and the second stack.

## Description

### TECHNICAL FIELD

The present disclosure relates, in general, to semiconductor structures. Aspects of the disclosure relate to a method of fabricating a complementary field effect transistor (CFET) having different gate lengths.

### BACKGROUND

Complementary Field Effect Transistors (CFETs) represent an advanced class of 3-dimensional semiconductor device structures designed to significantly enhance cell-area scaling. Unlike conventional two-dimensional configurations where n-type and p-type transistors are placed laterally (side-by-side), CFETs adopt a novel vertical stacking approach. This configuration arranges n-type and p-type transistors in a top/bottom (or p/n) orientation, thereby enabling a more compact and efficient design.

The primary advantage of CFETs lies in their potential to aggressively reduce the cell area, which is critical for advancing the miniaturisation of semiconductor devices. This innovative vertical integration facilitates higher transistor density and improved performance metrics. Previous approaches to CFET design have predominantly concentrated on the alignment of gate lengths (LG) between the top and bottom devices. Additionally, ensuring uniform thickness for both top and bottom transistors has been a focal point to maintain consistent electrical characteristics and device reliability.

### SUMMARY

An objective of the present disclosure is to provide a semiconductor structure having different gate lengths for improved performance.

The foregoing and other objectives are achieved by the features of the independent claims.

Further implementation forms are apparent from the dependent claims, the description and the Figures.

A first aspect of the present disclosure provides a method comprising forming a first stack of nanosheet layers on a substrate, forming a second stack of nanosheet layers on the first stack of nanosheet layers, wherein the nanosheet layers of the first stack and the second stack each comprise alternating silicon layers and silicon-germanium layers, wherein the silicon layers of the first stack have a first thickness and the silicon layers of the second stack have a second thickness, wherein the first stack and the second stack are separated by a sacrificial layer having a thickness greater than a thickness of the silicon-germanium layers of the first stack and the second stack.

Accordingly, the performance of CFET devices can be significantly improved by utilising different gate lengths for the n-type and p-type transistors. This is because N-type transistors (nFETs) typically benefit from shorter gate lengths due to their higher electron mobility, which results in faster switching speeds and reduced power consumption. Conversely, p-type transistors (pFETs) generally exhibit lower hole mobility, and thus, may perform better with longer gate lengths to minimize leakage currents and enhance drive strength. By customising the gate lengths to suit the intrinsic properties of nFETs and pFETs, CFET devices can achieve a more balanced and optimized performance. This approach allows for fine-tuning of electrical characteristics such as threshold voltage, drive current, and leakage, ultimately leading to improved efficiency, speed, and reliability of the overall device.

The sacrificial layer may comprise a silicon-germanium layer.

The first thickness may be greater than the second thickness, or the second thickness may be greater than the first thickness.

The method may further comprise etching the first stack and the second stack, whereby to form a plurality of fins in the alternating silicon layers and silicon-germanium layers of the first stack and the second stack.

The method may further comprise etching the first stack and the second stack, whereby to create a source/drain recess extending throughout the first stack and the second stack, and to form a shallow trench in the substrate.

The method may further comprise removing the sacrificial layer, and forming a dielectric insulation layer by placing a first dielectric in place of the removed sacrificial layer.

The first dielectric may comprise silicon nitride or silicon oxide

The method may further comprise forming a dummy gate around the dielectric insulation layer by depositing a dummy gate material.

The method may further comprise etching the silicon-germanium layers of the first stack and the second stack, whereby to create first cavity recesses in the first stack and second cavity recesses in the second stack, respectively, wherein the first cavity recesses have a first depth, wherein the second cavity recesses have a second depth, wherein the second depth is greater than the first depth, or the first depth is greater than the second depth.

The method may further comprise depositing a second dielectric in the first cavity recesses and the second cavity recesses, whereby to form a plurality of inner spacers.

The second dielectric may comprise silicon nitride, silicon carbon oxide, or silicon dioxide.

The first stack of nanosheet layers may correspond to a first field-effect transistor, and the second stack of nanosheet layers may correspond to a second field-effect transistor. The method may further comprise growing epitaxial semiconductor material in the source/drain recess of the first stack, whereby to create a source/drain region of the first field-effect transistor, and forming a first contact, whereby to provide electrical connectivity to the source/drain region of the first field-effect transistor.

The method may further comprise forming an insulating barrier between the first field-effect transistor and the second field-effect transistor.

The method may further comprise growing epitaxial semiconductor material in the source/drain recess of the second stack, whereby to create a source/drain region of the second field-effect transistor, and forming a top contact, whereby to provide electrical connectivity to the source/drain region of the second field-effect transistor.

The method may further comprise etching the first stack and the second stack, whereby to remove the silicon-germanium layers of the first stack and the second stack.

The first thickness may comprise a thickness in a range of approximately 4 to 6 nanometres, and the second thickness may comprise a thickness in a range of approximately 3 to 4 nanometres.

A second aspect of the present disclosure provides a semiconductor structure comprising a first field-effect transistor disposed on a substrate, the first field-effect transistor comprising a first gate and a first source/drain region, and a second field-effect transistor vertically stacked above the first field-effect transistor, the second field-effect transistor, a second gate and a second source/drain region, wherein the second gate is shorter than the first gate, or the first gate is shorter than the second gate.

The first gate may comprise a p-type work function metal and the second gate comprises an n-type work function metal, or the first gate comprises the n-type work function metal and the second gate comprises the p-type work function metal.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figures 1a-1f are schematical representations of a method of fabrication according to an example;
Figure 2 is a flow chart of a method according to an example; and
Figure 3 is a schematic representation of a semiconductor structure according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Forksheet devices are considered promising candidates for the extension of Gate-All-Around (GAA) based Nanowire and Nanosheet (NS) devices, which are anticipated to enter production shortly, as announced by all major semiconductor foundries. Despite their potential, FS devices face several disadvantages that impede their reliability and performance. One notable issue is the presence of a dielectric wall between the n-type and p-type devices. This dielectric wall introduces significant process complexity and unreliability, particularly concerning mechanical stress. Such stress imbalances can degrade the electrical performance and operational balance between the n-type and p-type transistors. Ideally, for optimal device functionality, it is crucial that both n-type and p-type transistors exhibit similar performance characteristics. The challenges presented by the dielectric wall in FS devices underscore the need for innovative solutions to achieve uniform performance in these advanced semiconductor structures.

According to an example, there is provided a semiconductor structure having different gate lengths for the n-type and p-type transistors. The performance of CFET devices can be enhanced by optimizing gate lengths to match the specific properties of n-type and p-type transistors. N-type transistors (nFETs) generally exhibit higher electron mobility, which allows them to achieve faster switching speeds and lower power consumption with shorter gate lengths. In contrast, p-type transistors (pFETs), which have lower hole mobility, benefit from longer gate lengths to reduce leakage currents and increase drive strength. By tailoring the gate lengths for nFETs and pFETs based on their unique characteristics, CFET devices can achieve a more balanced and optimized overall performance. This customization facilitates precise control over electrical parameters such as threshold voltage, drive current, and leakage, resulting in enhanced efficiency, speed, and reliability of the device.

Examples in the present disclosure can be provided as methods, systems or machine-readable instructions, such as any combination of software, hardware, firmware or the like. Such machine-readable instructions may be included on a computer readable storage medium (including but not limited to disc storage, CD-ROM, optical storage, etc.) having computer readable program codes therein or thereon.

The present disclosure is described with reference to flow charts and/or block diagrams of the method, devices and systems according to examples of the present disclosure. Although the flow diagrams described above show a specific order of execution, the order of execution may differ from that which is depicted. Blocks described in relation to one flow chart may be combined with those of another flow chart. In some examples, some blocks of the flow diagrams may not be necessary and/or additional blocks may be added. It shall be understood that each flow and/or block in the flow charts and/or block diagrams, as well as combinations of the flows and/or diagrams in the flow charts and/or block diagrams can be realized by machine readable instructions.

The machine-readable instructions may, for example, be executed by a machine such as a general-purpose computer, user equipment such as a smart device, e.g., a smart phone, a special purpose computer, an embedded processor or processors of other programmable data processing devices to realize the functions described in the description and diagrams. In particular, a processor or processing apparatus may execute the machine-readable instructions. Thus, modules of apparatus (for example, a module implementing a comparator unit, or a firewall structure and so on) may be implemented by a processor executing machine readable instructions stored in a memory, or a processor operating in accordance with instructions embedded in logic circuitry. The term 'processor' is to be interpreted broadly to include a CPU, processing unit, ASIC, logic unit, or programmable gate set etc. The methods and modules may all be performed by a single processor or divided amongst several processors.

Such machine-readable instructions may also be stored in a computer readable storage that can guide the computer or other programmable data processing devices to operate in a specific mode. For example, the instructions may be provided on a non-transitory computer readable storage medium encoded with instructions, executable by a processor.

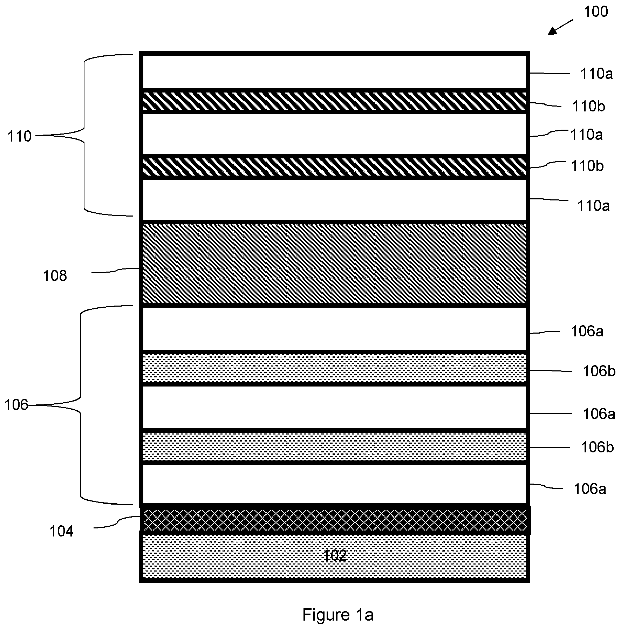

Figures 1a-1f are schematical representations of a method of fabrication according to an example.

Figure 1a shows the semiconductor structure 100 at a first stage of fabrication. The semiconductor structure 100 may be the result of epitaxially growing a plurality of nanosheets on substrate 102. In general, substrate 102 can be composed of any currently known or later developed semiconductor material such as, for example, silicon (Si), germanium (Ge), silicon germanium (SiGe) at various Si and Ge concentrations, silicon carbide (SiC), Si:C (carbon doped silicon), silicon germanium carbide (SiGeC), carbon doped silicon germanium (SiGe:C), compound semiconductor materials (e.g. Groups III-V), or other like semiconductor material. In addition, multiple layers of the semiconductor materials can be used as the semiconductor material of the substrate. The semiconductor substrate 102 can be a bulk substrate or a semiconductor-on-insulator substrate such as, but not limited to, a silicon-on-insulator (SOI), silicon-germanium-on-insulator (SGOI) or Groups III-V-on-insulator substrate including a buried insulating layer, such as, for example, a buried oxide, nitride layer or aluminium oxide.

A bottom sacrificial epitaxial layer 104 may be formed on substrate 102 by epitaxially growing a semiconductor material. A suitable semiconductor material for bottom sacrificial epitaxial layer 104 can be SiGe, such as, for example, SiGe₂₀₋₈₀. Representative examples of SiGeₓ can be SiGe₂₀, SiGe₂₅, SiGe₃₀ ... SiGe₆₅. The terms "epitaxial growth" and "epitaxially forming and/or growing" mean the growth of a semiconductor material on a deposition surface of a semiconductor material, in which the semiconductor material being grown may have the same crystalline characteristics as the semiconductor material of the deposition surface.

A first nanosheet stack 106 of alternating layers of silicon-germanium (SiGe) 106a and silicon (Si) 106b can be formed on top of bottom sacrificial epitaxial layer 104. While the first nanosheet stack 106 is depicted as having five layers (three SiGe layers and two Si layers), any number and combination of layers can be used, as long as the layers alternate between SiGe and Si. In an example, a thickness of the SiGe layers 106a may comprise a thickness in the range of 8-12 nm, while a thickness of the Si layers 106b may comprise a thickness in the range of 4-6 nm.

Next, a middle sacrificial layer 108 of SiGe may be disposed on a top surface of first nanosheet stack 106. Middle sacrificial epitaxial layer 108 can be of the same semiconductor material as the SiGe layers 106 a of first nanosheet stack 106. In generally, the middle sacrificial epitaxial layer 108 will have a thickness greater than the thickness of the SiGe layers 106a and the SiGe layers 1 10b. For example, the middle sacrificial epitaxial layer 108 can have a thickness of about 10-40 nm. Importantly, the Ge concentration of the middle sacrificial layer 108 may be higher than the Ge concentration of other layers.

A second nanosheet stack 110 of alternating layers of Si 110a and SiGe 110b may be disposed on middle sacrificial epitaxial layer 108. While the second nanosheet stack 110 is depicted with five layers (three SiGe layers and two Si layers), r any number and combination of layers can be used, as long as the layers alternate between SiGe layers and Si layers. In an example, a thickness of the SiGe layers 110a may comprise a thickness in the range of 8-12 nm, while a thickness of the Si layers 106b may comprise a thickness in the range of 3-4 nm.

Importantly, the thickness of the Si layers 106b of the first nanosheet stack 106 may be larger than the thickness of the Si layers 110b of the second nanosheet stack 110. The Ge concentration in the middle sacrificial epitaxial layer 108 may comprise 35-45%. The Ge concentration in the SiGe layers 110a of the second nanosheet stack 110 may comprise 25-35%. The Ge concentration in the SiGe layers 106a of the first nanosheet stack 106 may comprise 15-25%. Etch selectivity with respect to Si may be higher for the middle sacrificial epitaxial layer 108, followed by the SiGe layers 1 10a, with the lowest etch sensitivity with respect to Si for the SiGe layers 106a.

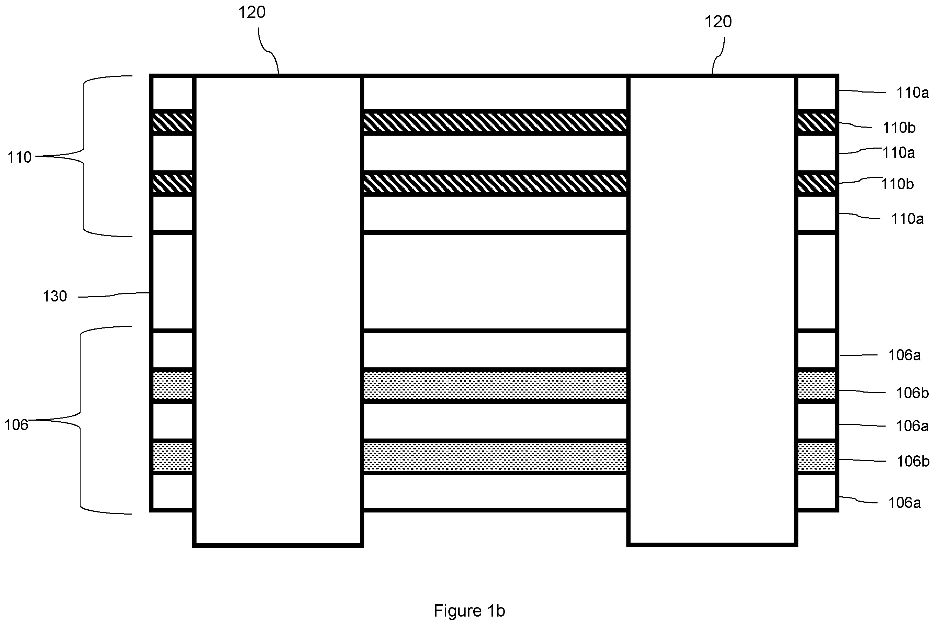

Figure 1b shows the semiconductor structure 100 at a second stage of fabrication. For the sake of convenience, the bottom epitaxial layer 104 and the substrate 102 are not shown in this Figure.

At this stage, several critical steps may take place. Initially, the first nanosheet stack 106 and the second nanosheet stack 110 may be patterned to create fin structures. Following this, shallow trench isolation (STI) may be performed to electrically isolate the fins.

The Middle Dielectric Isolation (MDI) 130 may be formed. The MDI 130 may serve to further isolate the active regions of the device, enhancing performance by reducing parasitic capacitance and leakage currents. The MDI 130 may comprise various dielectric materials, such as silicon nitride or silicon oxide, selected based on their insulating properties and compatibility with the overall device structure. The MDI may be formed by etching out the middle sacrificial epitaxial layer 108 and depositing the suitable dielectric material.

Following the formation of the MDI 130, the process may proceed to the formation of a dummy gate. This may involve depositing a sacrificial gate material over the fin structures and MDI. The dummy gate may serve as a placeholder for the final gate structure and aid in the precise definition of the gate length and alignment.

After STI, and other important steps such as dummy gate formation and source/drain spacer formation, a recess may be etched in the Source/Drain regions of the fin structures. The etching may be dry or chemical based, performed in order to create regions where Source/Drain epi will be grown. In Figure 1b, two recesses 120 and 120 are shown. These may help define the areas where the Source/Drain regions will be formed.

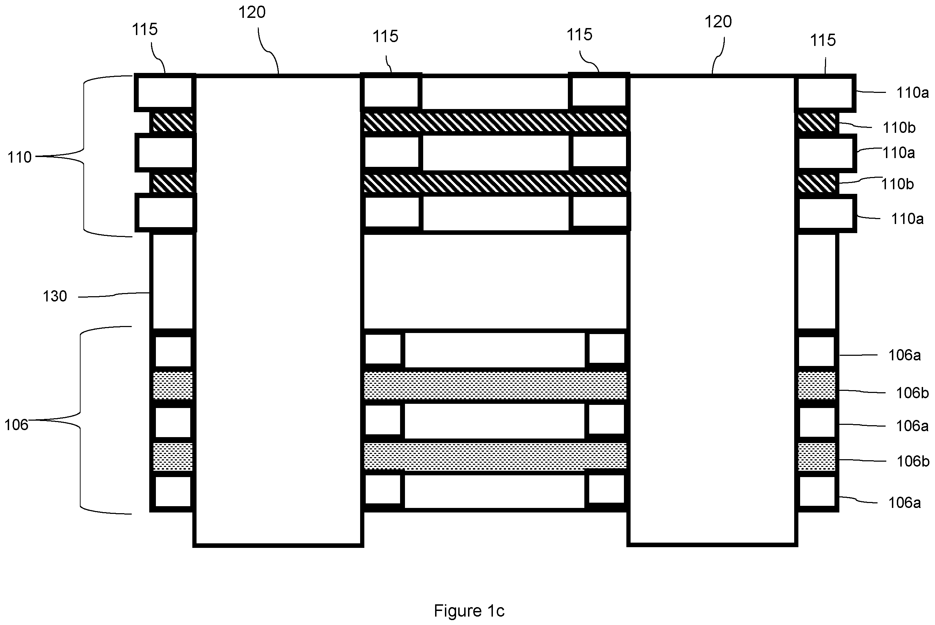

In Figure 1c, an inner-spacer cavity recess may be created for both the top and bottom devices. This may involve etching cavities 115 adjacent to the gate structures, which serve as spaces for the inner spacers. The etching process for the inner-spacer cavity may need to account for different etch depths for the top and bottom devices. This variation may be necessary due to the differing germanium concentrations in the Si/SiGe layer stack.

In particular, the higher germanium concentration in one layer (i.e., 110a, compared to 106a) may alter the etching characteristics, necessitating a deeper etch for the layer with higher germanium content to achieve uniformity and precision in the device structure. That is, the cavities 115 in the SiGe layers 110a of the second nanosheet stack 110 may be larger than the cavities 115 in the SiGe layers 106a of the first nanosheet stack 106. Advantageously, this can help ensure that both the top and bottom devices exhibit optimal performance.

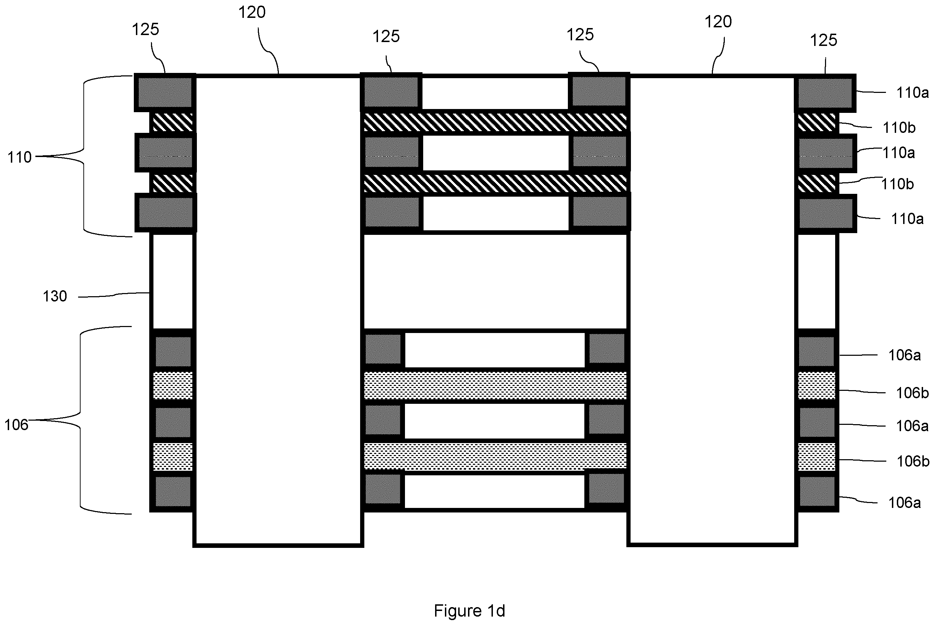

Figure 1d shows Inner Spacer (ISP) 125 formation, which may comprise introducing a ISP dielectric material into the recesses 115 created in the previous step. Initially, after forming the recesses 115 for the inner spacers adjacent to the dummy gate structures, an ISP dielectric material may be deposited. The dielectric material can be silicon nitride (SiN), silicon oxycarbide (SiCO), silicon dioxide (SiO2), a low-k dielectric material, or even an air gap, depending on the specific requirements of the device design.

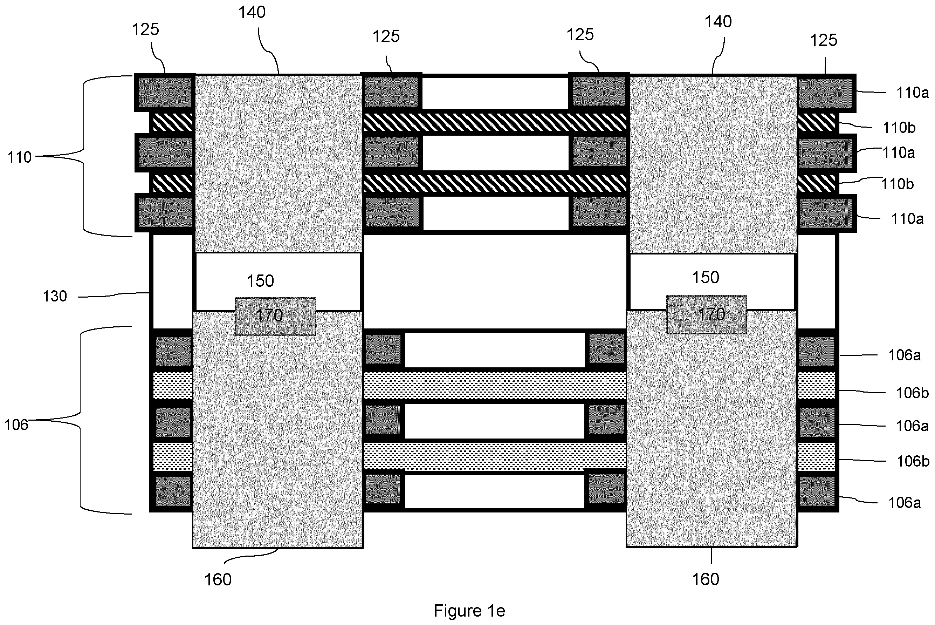

In Figure 1e, firstly, the bottom device S/D regions 160 may undergo epitaxial growth to form the desired semiconductor material. Following the bottom S/D 160 epitaxy, bottom contacts 170 may be formed. While bottom contacts 170 are shown in the Figure, the invention is not limited thereto, and the skilled person would appreciate that a top contact could be used instead. Forming the bottom contacts 170 may comprise depositing and patterning conductive materials to create electrical connections to the bottom S/D regions 160.

Next, n/p isolation may be performed to electrically separate the n-type and p-type devices, using, for example, isolation 150 shown in Figure 1e. The isolation 150 may be critical for preventing electrical interference between the different types of transistors and ensuring that each operates independently with minimal leakage. Finally, the top epitaxial layer 140 may be formed. This involves growing an epitaxial layer over the previously processed structures, similar to the bottom S/D epitaxy 160.

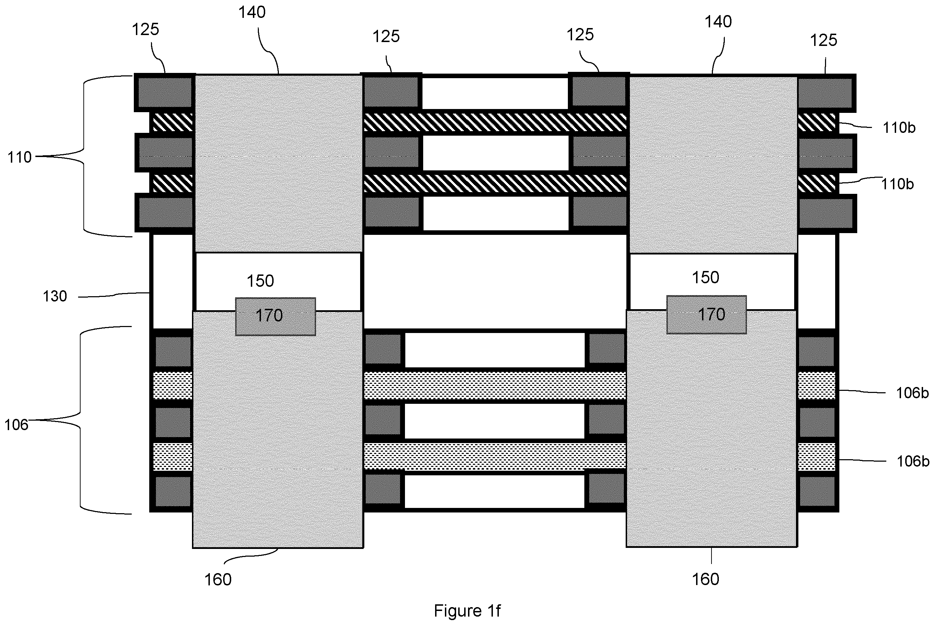

In Figure 1f, the sacrificial SiGe layers 106a of the first nanosheet stack 106 and the sacrificial SiGe layers 110a of the second nanosheet stack 110 may be selectively removed, creating the space needed for the subsequent gate formation process. Following the removal of the SiGe layer, an interlayer dielectric (ILD) may be deposited. This dielectric layer may serve to electrically isolate different device components. The ILD material can be selected based on the device requirements, with options including silicon dioxide (SiO2) or other suitable dielectrics.

A high-k dielectric material may be deposited. This material, characterized by its high dielectric constant, may be required for enhancing the gate capacitance without increasing leakage currents. Common high-k materials include hafnium oxide (HfO2) or zirconium oxide (ZrO2). Finally, the gate stack can be formed. This may comprise depositing and patterning the gate electrode materials over the high-k dielectric layer. The gate stack may include metals such as titanium nitride (TiN) or other suitable conductive materials, which provide the necessary work function to control the transistor's threshold voltage.

Importantly, the gate length of the first nanosheet stack 106 may be longer than the gate length of the second nanosheet stack 110, with the channel of the second nanosheet stack 110 being thinner than the channel of the first nanosheet stack 106. As discussed earlier in the specification, this offers improvements in performance.

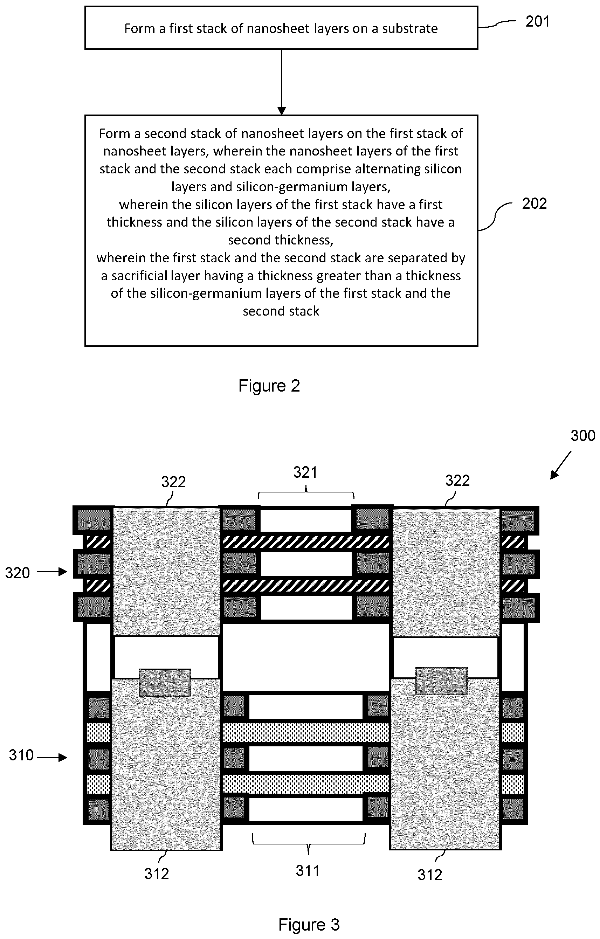

Figure 2 is a flow chart of a method according to an example. The method of Figure 2 may largely correspond to the method described above in relation to Figures 1a-1f. The method comprises, in block 201, forming a first stack of nanosheet layers on a substrate. The first stack of nanosheet layers may correspond to the first stack 106 of Figures 1a-1f.

The method comprises, in block 202, forming a second stack of nanosheet layers on the first stack of nanosheet layers, wherein the nanosheet layers of the first stack and the second stack each comprise alternating silicon layers and silicon-germanium layers, wherein the silicon layers of the first stack have a first thickness and the silicon layers of the second stack have a second thickness, wherein the first stack and the second stack are separated by a sacrificial layer having a thickness greater than a thickness of the silicon-germanium layers of the first stack and the second stack. The second stack of nanosheet layers may correspond to the second stack 110 of Figures 1a-1f.

Figure 3 is a schematic representation of a semiconductor structure according to an example. The semiconductor structure 300 comprises a first field-effect transistor 310 disposed on a substrate. The first field-effect transistor 310 comprises a first gate 311 and a first drain/source region 312. The semiconductor structure 300 comprises a second field-effect transistor 320, vertically stacked above the first field-effect transistor 310. The second field-effect 320 comprises a second gate 321 and a second drain/source region 322. Advantageously, the second gate 321 is shorter than the first gate 311, or the first gate 311 is shorter than the second gate 321.

The first gate 311 may comprise a p-type work function metal and the second gate 321 may comprise an n-type work function metal. In an alternative embodiment, the first gate 311 may comprise the n-type work function metal and the second gate 321 may comprise the p-type work function metal. As such, the performance of CFET devices can be significantly improved by utilising different gate lengths for the n-type and p-type transistors.

While various embodiments have been described and/or illustrated herein in the context of fully functional computing systems, one or more of these exemplary embodiments may be distributed as a program product in a variety of forms, regardless of the particular type of computer-readable-storage media used to actually carry out the distribution. The embodiments disclosed herein may also be implemented using software modules that perform certain tasks. These software modules may include script, batch, or other executable files that may be stored on a computer-readable storage medium or in a computing system. In some embodiments, these software modules may configure a computing system to perform one or more of the exemplary embodiments disclosed herein. In addition, one or more of the modules described herein may transform data, physical devices, and/or representations of physical devices from one form to another.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A method comprising:
forming a first stack of nanosheet layers on a substrate (201);
forming a second stack of nanosheet layers on the first stack of nanosheet layers (202),
wherein the nanosheet layers of the first stack and the second stack each comprise alternating silicon layers and silicon-germanium layers,
wherein the silicon layers of the first stack have a first thickness and the silicon layers of the second stack have a second thickness,
wherein the first stack and the second stack are separated by a sacrificial layer having a thickness greater than a thickness of the silicon-germanium layers of the first stack and the second stack.

2. The method of claim 1, wherein the first thickness is greater than the second thickness, or the second thickness is greater than the first thickness.

3. The method of claim 1, further comprising:
etching the first stack and the second stack, whereby to form a plurality of fins in the alternating silicon layers and silicon-germanium layers of the first stack and the second stack.

4. The method of claim 1, 2 or 3, further comprising:
etching the first stack and the second stack, whereby to create a source/drain recess extending throughout the first stack and the second stack, and to form a shallow trench in the substrate

5. The method of any one of claims 1 to 4, further comprising:
removing the sacrificial layer; and
forming a dielectric insulation layer by placing a first dielectric in place of the removed sacrificial layer.

6. The method of claim 5, wherein the first dielectric comprises silicon nitride or silicon oxide.

7. The method of claim 5 or 6, further comprising:
forming a dummy gate around the dielectric insulation layer by depositing a dummy gate material.

8. The method of any one of claims 1 to 7, further comprising:
etching the silicon-germanium layers of the first stack and the second stack, whereby to create first cavity recesses in the first stack and second cavity recesses in the second stack, respectively,
wherein the first cavity recesses have a first depth, wherein the second cavity recesses have a second depth,
wherein the second depth is greater than the first depth, or the first depth is greater than the first depth.

9. The method of any one of claims 1 to 8, further comprising:
depositing a second dielectric in the first cavity recesses and the second cavity recesses, whereby to form a plurality of inner spacers.

10. The method of claim 8, wherein the second dielectric comprises silicon nitride, silicon carbon oxide or silicon dioxide.

11. The method of any one of claims 1 to 10, wherein the first stack of nanosheet layers corresponds to a first field-effect transistor, wherein the second stack of nanosheet layers corresponds to a second field-effect transistor, the method further comprising:
growing epitaxial semiconductor material in the source/drain recess of the first stack, whereby to create a source/drain region of the first field-effect transistor; and
forming a first contact, whereby to provide electrical connectivity to the source/drain region of the first field-effect transistor.

12. The method of claim 11, further comprising:
forming an insulating barrier between the first field-effect transistor and the second field-effect transistor.

13. The method of claim 11 or 12, further comprising:
growing epitaxial semiconductor material in the source/drain recess of the second stack, whereby to create a source/drain region of the second field-effect transistor; and
forming a top contact, whereby to provide electrical connectivity to the source/drain region of the second field-effect transistor.

14. The method of any one of claims 1 to 13, further comprising:
etching the first stack and the second stack, whereby to remove the silicon-germanium layers of the first stack and the second stack.

15. The method of any one of claims 1 to 14, wherein the first thickness comprises a thickness in a range of approximately 4 to 6 nanometers, wherein the second thickness comprises a thickness in a range of approximately 3 to 4 nanometers.

16. A semiconductor structure comprising:
a first field-effect transistor (310) disposed on a substrate, the first field-effect transistor (310) comprising a first gate (311) and a first source/drain region (312); and
a second field-effect transistor (320) vertically stacked above the first field-effect transistor (310), the second field-effect transistor (320) comprising a second gate (321) and a second source/drain region (322),
wherein the second gate (321) is shorter than the first gate (311), or the first gate (311) is shorter than the second gate (321).

17. The semiconductor structure of claim 15, wherein the first gate (311) comprises a p-type work function metal and the second gate (321) comprises an n-type work function metal, or the first gate (311) comprises the n-type work function metal and the second gate (321) comprises the p-type work function metal.

## Amended claims

### Amended claims in accordance with Rule 137(2) EPC.

1. A method comprising:
forming (201) a first stack of nanosheet layers on a substrate (201);
forming (202) a second stack of nanosheet layers on the first stack of nanosheet layers (202),
wherein the nanosheet layers of the first stack and the second stack each comprise alternating silicon layers and silicon-germanium layers,
wherein the silicon layers of the first stack have a first thickness and the silicon layers of the second stack have a second thickness, wherein the first thickness is greater than the second thickness;
wherein the first stack and the second stack are separated by a sacrificial layer having a thickness greater than a thickness of the silicon-germanium layers of the first stack and the second stack;
wherein the method further comprises:
etching the first stack and the second stack, whereby to create a source/drain recess extending throughout the first stack and the second stack;
etching the silicon-germanium layers of the first stack and the second stack, whereby to create first cavity recesses in the first stack and second cavity recesses in the second stack, respectively,
wherein the first cavity recesses have a first depth, wherein the second cavity recesses have a second depth,
wherein the second depth is greater than the first depth;
depositing a second dielectric in the first cavity recesses and the second cavity recesses, whereby to form a plurality of inner spacers;
wherein the first stack of nanosheet layers corresponds to a first field-effect transistor, wherein the second stack of nanosheet layers corresponds to a second field-effect transistor, the method further comprising:
growing epitaxial semiconductor material in the source/drain recess of the first stack, whereby to create a source/drain region of the first field-effect transistor; and
forming a first contact, whereby to provide electrical connectivity to the source/drain region of the first field-effect transistor;
growing epitaxial semiconductor material in the source/drain recess of the second stack, whereby to create a source/drain region of the second field-effect transistor; and
forming a top contact, whereby to provide electrical connectivity to the source/drain region of the second field-effect transistor; and
etching the first stack and the second stack, whereby to remove the silicon-germanium layers of the first stack and the second stack; and
the method further comprises: forming a first gate stack on the first stack, and forming a second first stack on the second stack, wherein the first gate stack comprises a p-type work function metal and the second gate stack comprises an n-type work function metal.

2. The method of claim 1, further comprising:
etching the first stack and the second stack, whereby to form a plurality of fins in the alternating silicon layers and silicon-germanium layers of the first stack and the second stack.

3. The method of any one of claims 1 or 2, further comprising:
removing the sacrificial layer; and
forming a dielectric insulation layer by placing a first dielectric in place of the removed sacrificial layer.

4. The method of claim 3, wherein the first dielectric comprises silicon nitride or silicon oxide.

5. The method of claim 3 or 4, further comprising:
forming a dummy gate around the dielectric insulation layer by depositing a dummy gate material.

6. The method of any one of claims 1 to 5, wherein the second dielectric comprises silicon nitride, silicon carbon oxide or silicon dioxide.

7. The method of any one of claims 1 to 6, further comprising:
forming an insulating barrier between the first field-effect transistor and the second field-effect transistor.

8. The method of any one of claims 1 to 7, wherein the first thickness comprises a thickness in a range of approximately 4 to 6 nanometers, wherein the second thickness comprises a thickness in a range of approximately 3 to 4 nanometers.

9. A semiconductor structure comprising:
a first field-effect transistor (310) disposed on a substrate, the first field-effect transistor (310) comprising a first gate (311) and a first source/drain region (312); and
a second field-effect transistor (320) vertically stacked above the first field-effect transistor (310), the second field-effect transistor (320) comprising a second gate (321) and a second source/drain region (322),
wherein the second gate (321) is shorter than the first gate (311), or the first gate (311) is shorter than the second gate (321); and
wherein one or more first channels in the first field-effect transistor (310) are thinner than one or more second channels in the second field-effect transistor (320); and
wherein the first gate (311) comprises a p-type work function metal and the second gate (321) comprises an n-type work function metal.
